(19) Europäisches Patentamt
European Patent Office
Office européen des brevets

(11) EP 3 180 404 B1

(12) **EUROPEAN PATENT SPECIFICATION**

(45) Date of publication and mention of the grant of the patent:
**08.05.2019 Bulletin 2019/19**

(21) Application number: **15753331.6**

(22) Date of filing: **11.08.2015**

(51) Int Cl.:
***C09D 5/24*** *(2006.01)* ***C09D 11/52*** *(2014.01)*
***H01B 1/22*** *(2006.01)*

(86) International application number:
**PCT/EP2015/068421**

(87) International publication number:
**WO 2016/023887 (18.02.2016 Gazette 2016/07)**

(54) **COMPOSITION COMPRISING SILVER NANOWIRES AND STYRENE/(METH)ACRYLIC COPOLYMERS FOR THE PREPARATION OF ELECTROCONDUCTIVE TRANSPARENT LAYERS**

ZUSAMMENSETZUNG MIT SILBERNANODRÄHTEN UND STYROL/(METH)ACRYLAT-COPOLYMEREN ZUR HERSTELLUNG VON ELEKTRISCH LEITENDEN, TRANSPARENTEN SCHICHTEN

COMPOSITION COMPRENANT DES NANOFILS D’ARGENT ET DES COPOLYMÈRES STYRÈNE/(MÉTH)ACRYLIQUES PERMETTANT LA PRÉPARATION DE COUCHES TRANSPARENTES ÉLECTROCONDUCTRICES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.08.2014 US 201462037630 P**

(43) Date of publication of application:
**21.06.2017 Bulletin 2017/25**

(73) Proprietor: **BASF SE**
**67056 Ludwigshafen am Rhein (DE)**

(72) Inventors:
- **ZHANG, Rui**
**West New York, New Jersey 07093 (US)**
- **DIETSCH, Herve**
**67098 Bad Dürkheim (DE)**
- **GAO, Xuerong**
**07039 Livingston, NJ (US)**

(74) Representative: **BASF IP Association**
**BASF SE**
**G-FLP-C006**
**67056 Ludwigshafen (DE)**

(56) References cited:
**EP-A2- 2 594 613** **US-A1- 2013 251 983**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 180 404 B1

## Description

The present invention relates to a composition suitable for the preparation of an electroconductive transparent layer, a method for preparing an electroconductive transparent layer, an electroconductive transparent layer comprising or consisting of solid constituents of said composition, an article comprising said electroconductive transparent layer, and to the use of said composition for the preparation of said electroconductive layer or said article, respectively.

The term "electroconductive transparent layer" as used herein refers to a layer which (i) is capable of allowing the flow of an electric current when an appropriate voltage is applied and (ii) has a light transmission of 80 % or more in the visible region (400-700 nm) measured according to ASTM D1003, see e.g. US 8,049,333. Usually, said layer is arranged on the surface of a substrate, wherein said substrate is typically an electrical isolator. Such electroconductive transparent layers are widely used in flat liquid crystal displays, touch panels, electroluminescent devices, thin film photovoltaic cells, as anti-static layers and as electromagnetic wave shielding layers.

Typically, such electroconductive transparent layer is a composite comprising (i) an optically transparent contiguous solid phase (also referred to as a matrix) and (ii) a conductive network of electroconductive nanoobjects which extends throughout said matrix. The matrix is formed of one or more optically transparent polymers. Said matrix binds the electroconductive nanoobjects within the layer, fills the voids between said electroconductive nanoobjects, provides mechanical integrity and stability to the layer and binds the layer to the surface of the substrate. The conductive network of electroconductive nanoobjects allows for the flow of an electric current between adjacent and overlapping electroconductive nanoobjects within the layer. Due to the small dimensions of the nanoobjects, their influence on the optical behavior of the composite is quite small, thus allowing for the formation of an optically transparent composite, i.e. a composite having a light transmission of 80 % or more in the visible region (400-700 nm) measured according to ASTM D1003, see e.g. US 8,049,333.

Typically, such electroconductive transparent layers are prepared by applying a composition comprising sufficient amounts of

(i) one or more matrix-forming binding agents,

(ii) electroconductive nanoobjects and

(iii) optionally auxiliary constituents

dissolved or dispersed in a suitable liquid (preferably water) to a surface of a substrate, and removing those constituents which at 25 °C and 101.325 kPa are liquid (hereinbelow referred to as the liquid constituents) from said composition applied to said surface of said substrate to such extent that on said surface of said substrate an electroconductive transparent layer is formed which comprises constituents of the applied composition which at 25 °C and 101.325 kPa are solid (hereinbelow referred to as solid constituents). Such a composition for the preparation of an electroconductive transparent layer is commonly referred to as an ink.

US 2008/0182090 A1 discloses a composition which is suitable for use as an ink for high speed printing for producing electronic circuitry such as RFID antennas etc., said composition comprising the following constituents

(a) conductive particles, preferably silver particles, more preferably silver flakes

(b) styrene/(meth)acrylic copolymer

(c) an anionic wetting agent

(d) defoamer and

(e) water.

According to US 2008/0182090 A1, the obtained electroconductive layers have a thickness in the range of from 3 $\mu$m to 7 $\mu$m.

Preferably, in said ink according to US 2008/0182090 A1, the concentration of silver particles (a) is about 10 to 90 % of the composition, and the concentration the copolymer (b) is about 2 to 50 % of the composition. Accordingly, the concentration of constituents which at 25 °C and 101.325 kPa are solid (hereinbelow referred to as solid constituents) is remarkably high in said ink. US 2008/0182090 A1 is silent regarding the optical properties of the obtained electroconductive layers, however it is assumed that the light transmission is rather low and the haze is rather high because of the large amount of solid constituents in the ink. At a given wet thickness of the ink applied to the surface of a substrate for

the preparation of an electroconductive layer, the thickness and accordingly the opacity of the obtainable electroconductive layer increases with increasing concentration of solid constituents in the applied ink. Decreasing the thickness and opacity of the obtainable electroconductive layer by decreasing the wet thickness is hardly possible, because for technical reasons there is a lower limit of the wet thickness, and in order to obtain an electroconductive transparent layer at all, the wet thickness must be as close to said lower limit as possible.

WO 2013/073259 A1 discloses a polystyrene sulfonic acid (salt) which is useful as a dispersant for producing an aqueous dispersion of a nanocarbon material such as a carbon nanotube, graphene or fullerene or an aqueous dispersion of a conductive polymer.

US 2011/0171364 A1 discloses carbon-nanotube based pastes and methods for making and using the same.

US 2011/0097277 A1 discloses a particle, comprising: (a) a core and (b) a surface having a plurality of zwitterionic polymers grafted thereto or grafted therefrom.

US 2006/0167147 A1 relates to a process for the manufacture of metal-containing materials or composite materials, the process comprising the steps of encapsulating at least one metal-based compound in a polymeric shell, thereby producing a polymer-encapsulated metal-based compound and/or coating a polymeric particle with at least one metal-based compound; forming a sol from suitable hydrolytic or non-hydrolytic sol/gel forming components; combining the polymer-encapsulated metal-based compound and/or the coated polymeric particle with the sol, thereby producing a combination thereof; and converting the combination into a solid metal-containing material.

It is an object of the present invention to provide an ink suitable for the preparation of an electroconductive transparent layer having a light transmission of 80 % or more measured according to ASTM D1003 (Procedure A). Further preferably, said electroconductive transparent layer shall exhibit a sheet resistance of 1000 Ohm/square or less as measured by the four point probe. Further preferably, said electroconductive transparent layer shall exhibit a haze of 2 % or less as measured according to ASTM D1003 (Procedure A), and a sheet resistance of 1000 Ohm/square or less as measured by the four point probe. In the context of the present invention, any reference to ASTM D1003 refers to the version published in November 2013.

These and other objects are achieved by a composition according to the present invention, said composition comprising the constituents

(A) water,

(B) electroconductive nanoobjects,
said electroconductive nanoobjects (B) having two external dimensions in the range of from 1 nm to 100 nm and their third external dimension in the range of from 1 μm to 100 μm,
wherein the weight fraction of said electroconductive nanoobjects (B) is in the range of from 0.01 wt.-% to 1 wt.-% based on the total weight of the composition,

(C) dissolved in the water one or more styrene/(meth)acrylic copolymers,
said dissolved copolymers (C) each having a number average molecular weight in the range of from 500 g/mol to 22000 g/mol,
wherein the total weight fraction of said dissolved copolymers (C) is in the range of from 0.02 wt.-% to 5 wt.-%, based on the total weight of the composition.

Hereinbelow, a composition according to the invention (as defined above) is also referred to as an ink.

Surprisingly, it has been found that a composition as defined above which comprises a significantly lower amount of solid constituents than the above-mentioned composition (ink) according to US 2008/0182090 A1 is suitable for the preparation of electroconductive transparent layers having superior optical properties as well as satisfying electronic conductivity. In the prior art, inks comprising a rather large concentration of electroconductive nanoobjects have been preferred in order to ensure a high electronic conductivity. Furthermore, US 2008/0182090 A1 focuses on reducing the thermal energy required for drying of the ink, and therefore is limited to inks having a rather high concentration of solid constituents. However, surprisingly it has been found that electroconductive transparent layers having superior optical properties as well as satisfying electronic conductivity can be prepared without incurring excessive requirements of thermal energy for drying when the composition according to the present invention (as defined above) is used.

In the composition according to the invention (as defined above), the main constituent which at 25 °C and 101.325 kPa is liquid is water (A), and the main constituents which at 25 °C and 101.325 kPa are solid are the above-defined electroconductive nanoobjects (B) and the above-defined one or more copolymers (C). In the composition according to the present invention (as defined above), the total concentration of constituents which at 25 °C and 101.325 kPa are solid (solid constituents) is 10 wt.-% or less, preferably 8 wt.-% or less, further preferably 5 wt.-% or less, in each case based on the total weight of said composition.

According to ISO/TS 27687:2008 (as published in 2008), the term "nanoobject" refers to an object having one,

two or three external dimensions in the nanoscale, i.e. in the size range from approximately 1 nm to 100 nm. The electroconductive nanoobjects to be used for the present invention are electroconductive nanoobjects having two external dimensions in the range of from 1 nm to 100 nm and their third external dimension in the range of from 1 μm to 100 μm. Typically, said two external dimensions which are in the range of from 1 nm to 100 nm are similar i.e. they differ in size by less than three times. The third dimension of said electroconductive nanoobjects (B) is significantly larger, i.e. it differs from the other two external dimensions by more than three times.

According to ISO/TS 27687:2008 (as published in 2008), nanoobjects having two similar external dimensions in the nanoscale, while the third external dimension is significantly larger, are generally referred to as nanofibers. Electrically conductive nanofibers are also referred to as nanowires. Hollow nanofibers (irrespective of their electrical conductivity) are also referred to as nanotubes.

Electroconductive nanoobjects (B) as defined above which are to be used for the present invention typically have a cross section close to circular shape. Said cross section extends perpendicularly to said external dimension which is in the range of from 1 μm to 100 μm. Thus, said two external dimensions which are in the nanoscale are defined by the diameter of said circular cross section. Said third external dimension extending perpendicularly to said diameter is referred to as the length.

Preferably, a composition according to the present invention comprises electroconductive nanoobjects (B) having a length in the range of from 1 μm to 100 μm, preferably of from 3 μm to 50 μm, more preferably of from 10 μm to 50 μm, and a diameter in the range of from 1 nm to 100 nm, preferably of from 2 nm to 50 nm, more preferably of from 3 nm to 30 nm.

Preferably, in the composition according to the invention (as defined above) the weight fraction of said electroconductive nanoobjects (B) as defined above is 0.8 wt.-% or less, preferably 0.5 wt-% or less, based on the total weight of the composition. The weight fraction of said electroconductive nanoobjects (B) is not less than 0.01 wt.-%, based on the total weight of the composition, because a weight fraction of less than 0.01 wt.-% of electroconductive nanoobjects (B) may be not sufficient for forming a conductive network, so that such composition is not suitable for preparing an electroconductive layer. Further preferably the weight fraction of said electroconductive nanoobjects (B) is not less than 0.02 wt.-%, preferably not less than 0.05 wt.-%.

Preferably, in the composition according to the invention (as defined above), the total weight fraction of said dissolved copolymers (C) is less than 2 wt.-%, more preferably 1.8 wt.-% or less, further preferably 1.5 wt.-% or less, especially preferably 1 wt.-% or less, based on the total weight of the composition. The total weight fraction of said dissolved copolymers (C) is not less than 0.02 wt.-%, based on the total weight of the composition, because a total weight fraction of less than 0.02 wt.-% of said dissolved copolymers (C) may be not sufficient for binding the electroconductive nanoobjects (B) so that such composition is not suitable for preparing an electroconductive layer. Further preferably the total weight fraction of said dissolved copolymers (C) is not less than 0.05 wt.-%, preferably not less than 0.1 wt.-%.

Preferably, in the composition according to the present invention (as defined above), the ratio between the total weight of said electroconductive nanoobjects (B) and the total weight of said dissolved copolymers (C) is in the range of from 1:20 to 20:1, preferably from 1:10 to 5:1, further preferably from 1:5 to 5:1.

The term "electroconductive nanoobject" means that the nanoobject comprises or consists of one or more materials capable of allowing the flow of electrons. Accordingly, a plurality of such electroconductive nanoobjects may form a conductive network of adjacent and overlapping nanoobjects extending throughout said matrix capable of carrying an electric current, provided that there is sufficient interconnection (mutual contact) between individual electroconductive nanoobjects so as to enable the transport of electrons along the interconnected electroconductive nanoobjects within the network.

Preferably, said electroconductive nanoobjects (B) comprise or consist of one or more materials selected from the group consisting of silver, copper, gold and carbon.

Preferably, the electroconductive nanoobjects (B) have a length in the range of from 1 μm to 100 μm and a diameter in the range of from 1 nm to 100 nm, wherein said electroconductive nanoobjects (B) comprise one or more materials selected from the group consisting of silver, copper, gold and carbon.

Preferably, said electroconductive nanoobjects (B) are selected from the group consisting of nanowires and nanotubes. Preferred nanowires comprise or consist of one or more metals selected from the group consisting of silver, copper and gold. Preferably, said nanowires each comprise at least 50 wt.-% of one or more metals selected from the group consisting of silver, copper and gold, based on the total weight of said nanowire. Most preferred are nanowires each comprising 50 wt.-% or more of silver based on the total weight of said nanowire (hereinbelow also referred to as "silver nanowires").

Preferred nanotubes are carbon nanotubes.

Among nanowires and nanotubes, nanowires are preferred.

Most preferred electroconductive nanoobjects (B) according to the present invention are silver nanowires having the above-mentioned dimensions.

Suitable electroconductive nanoobjects (B) as defined above are known in the art and are commercially available.

Silver nanowires (as well as nanowires of other metals) are typically commercially available in the form of an aqueous dispersion wherein polyvinylpyrrolidone is adsorbed onto the surface of the silver nanowires in order to render the dispersion stable. Any matter adsorbed on the surface of the nanowires is not included in the above-defined dimensions and composition of the electroconductive nanoobjects (B).

Preferably, the silver nanowires are obtained by the procedure described by Yugang Sun and Younan Xia in Adv. Mater 2002 14 No. 11, June 5, pages 833-837.

In preferred embodiments the composition according to the present invention does not comprise carbon nanotubes.

Constituent (C) of the composition according to the present invention (as defined above) consists of one or more styrene/(meth)acrylic copolymers dissolved in water wherein said dissolved copolymers (C) each have a number average molecular weight in the range of from 500 g/mol to 22000 g/mol. Herein, the term "(meth)acrylic" includes "methacrylic" and "acrylic". In said copolymers (C), each molecule comprises or consists of units derived from monoalkenyl aromatic monomers and units derived from (meth)acrylic monomers in copolymerized form. Such copolymers (C) are obtainable by copolymerisation of one or more kinds of monoalkenyl aromatic monomers with one or more kinds of (meth)acrylic monomers.

In preferred copolymers (C), each molecule comprises or consists of

- units C1 derived from monoalkenyl aromatic monomers MC1
  and

- units C2 derived from (meth)acrylic monomers MC2
  in copolymerized form.

Said units C1 (units derived from monoalkenyl aromatic monomers) have the chemical structure

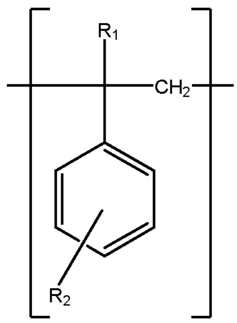

(C1)

wherein $R_1$, independently from the $R_1$ of each other unit C1, is selected from the group consisting of hydrogen and alkyl (including unbranched alkyl, preferably methyl, and branched alkyl, preferably tert-butyl)

and wherein $R_2$, independently from the $R_2$ of each other unit C1, is selected from the group consisting of halogen (preferably chlorine) and alkyl (preferably methyl), and $R_2$ is situated in a position selected from the group consisting of ortho, meta and para.

**[0038]** Said units C2 (units derived from (meth)acrylic monomers) have the chemical structure

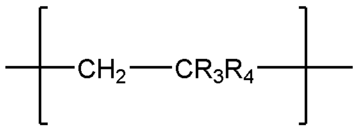

(C2)

wherein $R_3$, independently from the $R_3$ of each other unit C2, is selected from the group consisting of hydrogen, methyl, halogen (preferably chlorine) and cyano,

and wherein $R_4$, independently from the $R_4$ of each other unit C2, is selected from the group consisting of

-COOH,

-COOX wherein X is a cation selected from alkali metal cations, ammonium cations and substituted ammonium cations,

-CN,

$-COOR_5$ wherein $R_5$ is selected from the group consisting of branched and unbranched alkyl groups, branched and unbranched alkenyl groups, branched and unbranched alkinyl groups, cycloalkyl groups, aralkyl groups, aralkenyl groups, furfuryl, tetrahydrofurfuryl, isopropylidene glyceryl, glycidyl and tetrahydropyranyl, wherein said branched and unbranched alkyl groups , alkenyl groups and alkinyl groups include branched and unbranched alkyl groups substituted with one or more groups selected from the group consisting of hydroxy, alkoxy, phenoxy, halogen, sulfo, nitro, oxazolidinyl, monoalkylamino and dialkylamino groups

-CHO,

$-NR_6R_7$ wherein $R_6$ and $R_7$ are independently selected from the group consisting of hydrogen, alkyl and phenyl.

Such copolymers (C) are obtainable by copolymerisation of one or more kinds of monoalkenyl aromatic monomers MC1 having the formula

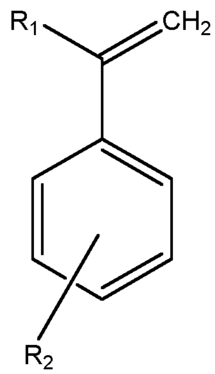

**(MC1)**

wherein $R_1$, independently from the $R_1$ of each other monomer MC1, is selected from the group consisting of hydrogen and alkyl (including unbranched alkyl, preferably methyl, and branched alkyl, preferably tert-butyl)

and wherein $R_2$, independently from the $R_2$ of each other monomer MC1, is selected from the group consisting of halogen (preferably chlorine) and alkyl (preferably methyl) and $R_2$ is situated in a position selected from the group consisting of ortho, meta and para,

with one or more kinds of (meth)acrylic monomers MC2 having the formula

$H_2C=CR_3R_4$ **(MC2)**

wherein $R_3$, independently from the $R_3$ of each other monomer MC2, is selected from the group consisting of hydrogen, methyl, halogen (preferably chlorine) and cyano,

and wherein $R_4$, independently from the $R_4$ of each other unit C1 is selected from the group consisting of

-COOH,

-COOX wherein X is a cation selected from alkali metal cations, ammonium cations and substituted ammonium cations,

-CN,

$-COOR_5$ wherein $R_5$ is selected from the group consisting of branched and unbranched alkyl groups, branched and unbranched alkenyl groups, branched and unbranched alkinyl groups, cycloalkyl groups, aralkyl groups, aralkenyl groups, furfuryl, tetrahydrofurfuryl, isopropylidene glyceryl, glycidyl and tetrahydropyranyl, wherein said branched and unbranched alkyl groups, alkenyl groups and alkinyl groups include alkyl groups, alkenyl groups and alkinyl groups substituted with one or more groups selected from the group consisting of hydroxy, alkoxy, phenoxy, halogen, sulfo, nitro, oxazolidinyl, monoalkylamino and dialkylamino groups

-CHO,

$-NR_6R_7$ wherein $R_6$ and $R_7$ are independently selected from the group consisting of hydrogen, alkyl and phenyl.

The term "(meth)acrylic monomer" MC2 as employed herein includes acrylic acid and salts, esters and amides of acrylic acid, acrylonitrile and acrolein, as well as methacrylic acid and salts, esters and amides of methacrylic acid, methacrylonitrile, and methacrolein.

(Meth)acrylic monomers, wherein $R_3$ is hydrogen or methyl, resp., and $R_4$ is -COOH, are acrylic acid or methacrylic acid, resp.

(Meth)acrylic monomers wherein $R_3$ is hydrogen or methyl, resp., and $R_4$ is $-COOR_5$ as defined above, are esters of acrylic acid or esters of methacrylic acid, resp.

(Meth)acrylic monomers wherein $R_3$ is hydrogen or methyl, resp., and $R_4$ is -COOX as defined above, are salts of acrylic acid or salts of methacrylic acid, resp.

(Meth)acrylic monomers wherein $R_3$ is hydrogen or methyl, resp., and $R_4$ is -CN, are acrylonitrile or methacrylonitrile, resp. Copolymers (C) obtainable by copolymerization of one or more kinds of monoalkenyl aromatic monomers MC1 and one or more (meth)acrylic monomers from the group consisting of acrylonitrile and methacrylonitrile and no other (meth)acrylic monomers MC2 are not preferred. In this regard it is preferred that for the preparation of copolymer (C) (meth)acrylic monomers selected from the group consisting of acrylonitrile and methacrylonitrile are used in combination with other (meth)acrylic monomers MC2 as defined herein.

(Meth)acrylic monomers wherein $R_3$ is hydrogen or methyl, resp., and $R_4$ is $-NR_6R_7$ as defined above, are amides of acrylic acid or amides of methacrylic acid, resp.

(Meth)acrylic monomers wherein $R_3$ is hydrogen or methyl, resp., and $R_4$ is -CHO are acrolein or methacrolein, resp.

Preferable monoalkenyl aromatic monomers MC1 are selected from the group consisting of alpha-methyl styrene, styrene, vinyl toluene, tertiary butyl styrene and ortho-chlorostyrene.

Examples of suitable (meth)acrylic monomers include the following methacrylate esters (methacrylic acid esters): methyl methacrylate, ethyl methacrylate, n-propyl methacrylate, n-butyl methacrylate, isopropyl methacrylate, isobutyl methacrylate, n-amyl methacrylate, n-hexyl methacrylate, isoamyl methacrylate, 2-hydroxyethyl methacrylate, 2-hydroxypropyl methacrylate, N,N-dimethylaminoethyl methacrylate, N,N-diethylaminoethyl methacrylate, t-butylaminoethyl methacrylate, 2-sulfoethyl methacrylate, trifluoroethyl methacrylate, glycidyl methacrylate, benzyl methacrylate, allyl methacrylate, 2-n-butoxyethylmethacrylate, 2-chloroethyl methacrylate, secbutyl-methacrylate, tert-butyl methacrylate, 2-ethylbutyl methacrylate, cinnamyl methacrylate, crotyl methacrylate, cyclohexyl methacrylate, cyclopentyl methacrylate, 2-ethoxyethyl methacrylate, furfuryl methacrylate, hexafluoroisopropyl methacrylate, methallyl methacrylate, 3-methoxybutyl methacrylate, 2-methoxybutyl methacrylate, 2-nitro-2-methylpropyl methacrylate, n-octylmethacrylate, 2-ethylhexyl methacrylate, 2-phenoxyethyl methacrylate, 2-phenylethyl methacrylate, phenyl methacrylate, prop-2-inyl methacrylate, tetrahydrofurfurylmethacrylate and tetrahydropyranylmethacrylate. Typical acrylate esters employed include: methyl acrylate, ethyl acrylate, n-propyl acrylate, isopropyl acrylate, n-butyl acrylate and n-decyl acrylate, methyl alpha-chloroacrylate, methyl 2-cyanoacrylate. Other suitable (meth)acrylic monomers include methacrylonitrile, methacrylamide, N-methylmethacrylamide, N-ethylmethacrylamide, N,N-diethylmethacrylamide, N,N-dimethylmethacrylamide, N-phenylmethacrylamide and methacrolein, acrylonitrile, acrylamide, N-ethylacrylamide, N,N-diethylacrylamide and acrolein.

Esters of methacrylic acid or acrylic acid containing a suitable condensable cross linkable functional group may be used as the monomer. Among such esters are t-butylaminoethyl methacrylate, isopropylidene glyceryl methacrylate and oxazolidinylethyl methacrylate.

Typical preferred cross-linkable acrylates and methacrylates include hydroxy alkyl acrylates, hydroxyl alkyl methacrylates and hydroxyesters of glycidyl acrylates or methacrylates. Examples of preferred hydroxy functional monomers include 2-hydroxyethyl acrylate, 3-chloro-2-hydroxypropyl acrylate, 2-hydroxy-butyl acrylate, 6-hydroxyhexyl acrylate, 2-hydroxymethyl methacrylate, 2-hydroxypropyl methacrylate, 6-hydroxyhexyl methacrylate, 5,6-dihydroxyhexyl methacrylate and the like.

The term "styrene/(meth)acrylic copolymer" as employed herein includes copolymers obtainable from mixtures consisting of two or more (meth)acrylic monomers and one or more monoalkenyl aromatic monomers, as well as copolymers obtainable from mixtures of at least one (meth)acrylic monomer and at least one non-acrylic ethylenic monomer and one or more monoalkenyl aromatic monomers. Suitable ethylenic monomers include: vinyl pyridine, vinyl pyrrolidone, sodium crotonate, methyl crotonate, crotonic acid and maleic anhydride.

For further details regarding the above-defined copolymers (C), reference is made to US 2008/0182090, US 4,414,370, US 4,529,787, US 4,546,160, US 5,508,366 and the prior art cited therein.

The number average molecular weight of each of said copolymers (C) is in the range of from 500 g/mol to 22000 g/mol, preferably of from 1700 g/mol to 15500 g/mol, further preferably of from 5000 g/mol to 10000 g/mol.

Typically, the water-soluble copolymers (C) are amphiphilic, because their molecules contain non-polar hydrophobic regions derived from the monoalkenyl aromatic monomers and polar hydrophilic regions derived from the (meth)acrylic monomers. Thus, the desired amphiphilic behavior is obtainable by appropriate selection of the hydrophobic monoalkenyl aromatic monomers and the hydrophilic (meth)acrylic monomers and appropriate adjustment of the ratio between monoalkenyl aromatic monomers and (meth)acrylic monomers so that a copolymer (C) is obtained which has an appropriate ratio between hydrophobic units derived from monoalkenyl aromatic monomers and hydrophilic units derived from (meth)acrylic monomers to allow for amphiphilic behavior of the copolymer. In aqueous solution said water-soluble copolymers (C) behave like surfactants (tensides), i.e. they are capable of forming micelles. A micelle is an aggregate formed by association of dissolved amphiphilic molecules. Preferably said micelles have a diameter of up to 5 nm.

Typical water-soluble copolymers (C) are known in the art and commercially available. Typically such copolymers are commercially available in the form of aqueous solutions.

In preferred embodiments the composition according to the present invention (as defined above) consists of the constituents (A), (B) and (C) as defined above.

In alternative preferred embodiments, the composition according to the present invention (as defined above) comprises one or more further constituents which are capable of co-acting with the above-defined one or more copolymers (C) in forming a matrix and binding the above-defined electroconductive nanoobjects (B). Those constituents are referred to as additional binding agents and belong to the solid constituents of the composition. Those additional binding agents are selected from the group of substances which are capable of forming a matrix and binding the above-defined electroconductive nanoobjects (B) in the absence of any copolymers (C) (as defined above). Those additional binding agents are not selected from the group consisting of styrene/(meth)acrylic copolymers having a number average molecular weight in the range of from 500 g/mol to 22000 g/mol (copolymers (C) as defined above and electroconductive nanoobjects (B) as defined above. Preferably, the total weight fraction of said additional binding agents (based on the total weight of the composition) is equal to or less than the total weight fraction of said dissolved copolymers (C) based on the total weight of the composition.

In the composition according to the invention, the total weight fraction of said one or more dissolved copolymers (C) and said one or more additional binding agents as defined above is preferably 7.5 wt.-% or less, preferably 3 wt.-% or less, further preferably 2.25 wt.-% or less, based on the total weight of the composition. Preferably, the total weight fraction of said additional binding agents (based on the total weight of the composition) is equal to or less of the total weight fraction of said dissolved copolymers (C) based on the total weight of the composition.

Preferably, said additional binding agents comprised by the composition according to the present invention (as defined above) are selected from the group consisting of

(D) dispersed in the water, particles of a polymer having a number average molecular weight of 25000 g/mol or higher, wherein said dispersed particles (D) have a mean diameter in the range of from 10 nm to 1000 nm,

(E) dispersed in the water, fibers of crystalline cellulose,
said dispersed fibers (E) of crystalline cellulose having a length in the range of from 80 nm to 300 nm and a diameter in the range of from 5 nm to 30 nm,

(F) dissolved in the water, one or more water-soluble polymers selected from the group consisting of hydroxypropyl methyl cellulose, carboxymethyl cellulose, polyacrylamide, polyvinylalcohol, polyvinylpyrrolidone, polystyrenesulfonic acid and dextran.

Said particles (D) of a polymer having a number average molecular weight of 25000 g/mol or higher are polymer beads each consisting of several entangled polymer chains. Said polymer beads are dispersed as a disperse phase in

an aqueous dispersion medium Said polymer beads have a mean diameter in the range from 10 nm to 1000 nm, in particular in the range from 50 nm to 600 nm determined by dynamic light scattering on an aqueous polymer dispersion (from 0.005 to 0.01 percent by weight) at 23 °C by means of an Autosizer IIC from of Malvern Instruments, England. Such aqueous polymer dispersions are obtainable in particular by free-radically initiated aqueous emulsion polymerization of ethylenically unsaturated monomers. Preferably, the number average molecular weight of the polymer of the particles (D) is not higher than 200000 g/mol. For further details, reference is made to US 7,999,045 B2 and the prior art cited therein as well as to the patent application "Composition comprising silver nanowires and dispersed polymer beads for the preparation of electroconductive transparent layers" filed by the same assignee on the same day like the present application.

Said fibers (E) are also referred to as nanocrystalline cellulose or cellulose nanofibers or cellulose II. They are obtainable by disrupting the amorphous domains of natural cellulose fibers and disintegration of the micrometer-sized cellulose fibers into rod-like rigid crystallites. The obtained crystallites typically have the above-mentioned dimensions.

More specifically, crystalline cellulose fibers (E) having the above-mentioned dimensions are obtainable by chemical treatment or by enzymatic treatment or by mechanical treatment of natural cellulose fibers or by combinations of different types of treatment, e.g. chemical treatment (e.g. with sulfuric acid or sodium chlorite) or enzymatic treatment followed by high-pressure homogenization, or by milling of natural cellulose fibers and subsequent hydrolysis to remove amorphous regions.

When an aqueous dispersion of fibers (E) of crystalline cellulose is dried, the cellulose fibers (E) are densely packed together by capillary action during the evaporation of the water. Accordingly, said cellulose fibers (E) are capable of co-acting with said one or more copolymers (C) in binding the electroconductive nanoobjects (B). Furthermore, due to their outstanding mechanical stability, said fibers (E) impart mechanical reinforcement to the obtained electroconductive transparent layer. For further details, reference is made to the patent application "Composition comprising silver nanowires and fibers of crystalline cellulose for the preparation of electroconductive transparent layers" filed by the same assignee on the same day like the present application.

Suitable additional binding agents, especially those defined above as (D), (E) and (F), are known in the art and are commercially available.

In a specific preferred embodiment, the composition according to the present invention comprises or consists of the above-defined constituents (A), (B) and (C), and

> (D) dispersed in the water particles of a polymer having a number average molecular weight of 25000 g/mol or higher, wherein said dispersed particles (D) have a largest dimension in the range of from 10 nm to 1000 nm,
> and no further additional binding agent,
> wherein the total weight fraction of said particles (D), based on the total weight of the composition, is equal to or less than the total weight fraction of said dissolved copolymers (C) based on the total weight of the composition.
> In another specific preferred embodiment, the composition according to the present invention comprises or consists of the above-defined constituents (A), (B) and (C), and
>
> (E) dispersed in the water fibers of crystalline cellulose,
> said dispersed fibers (E) of crystalline cellulose having a length in the range of from 80 nm to 300 nm and a diameter in the range of from 5 nm to 30 nm,
> and no further additional binding agent,
> wherein the weight fraction of said fibers (E), based on the total weight of the composition, is equal to or less than the total weight fraction of said dissolved copolymers (C) based on the total weight of the composition.

In another preferred embodiment, the composition according to the present invention comprises or consists of the above-defined constituents (A), (B) and (C), and
(F) one or more water-soluble polymers as defined above
and no further additional binding agent,
wherein the total weight fraction of said one or more water-soluble polymers (F), based on the total weight of the composition, is equal to or less than the total weight fraction of said dissolved copolymers (C) based on the total weight of the composition.

In preferred embodiments, a composition according to the present invention (as defined above) comprises one or more additional binding agents which are not water-soluble. Preferred additional binding agents which are not water-soluble are those defined above as (D) and (E). Electroconductive layers obtainable from such compositions exhibit an increased stability against moisture.

The composition according to the present invention optionally comprises further constituents beside the above-defined constituents (A) to (C), e.g. defoaming agents, rheological controlling agents, corrosion inhibitors and other auxiliary agents. Typical defoaming agents, rheological controlling agents and corrosion inhibitors are known in the art

and commercially available. However, surprisingly it has been found that compositions according to the invention (as defined above) which do not contain any further constituents beyond the above-defined constituents (A)-(C) and optionally one or more of above-defined constituents (D)-(F) are suitable for the preparation of electroconductive transparent layers having superior optical properties as well as satisfying electronic conductivity. Accordingly, the addition of any auxiliary agents can be omitted, thus rendering the composition less complex and facilitating preparation of such composition. Accordingly, in preferred embodiments a composition according to the present invention consists of above-defined constituents (A)-(C) and optionally one or more of above-defined constituents (D)-(F). Nevertheless, in certain embodiments the composition according to the present invention (as defined above) comprises one or more auxiliary agents, especially those as defined above.

It is understood that any further constituents (beside the above-defined constituents (A) to (C)) of the composition according to the present invention (as defined above) as well as the amounts of such further constituents have to be selected in such manner that the electrical conductivity and the optical properties of a layer obtainable from said composition are not compromised.

Preferred compositions according to the present invention are those wherein two or more of the above-defined preferred features are combined.

Particularly preferred is a composition according to the present invention, said composition comprising or consisting of

(A) water

(B) silver nanowires
said silver nanowires (B) having a length in the range of from 10 μm to 50 μm and a diameter in the range of from 3 nm to 30 nm
wherein the weight fraction of said silver nanowires (B) is 0.5 wt.-% or less, based on the total weight of the composition

(C) dissolved in the water a styrene/(meth)acrylic copolymer,
said dissolved copolymer (C) having a number average molecular weight in the range of from 1700 g/mol to 15500 g/mol
wherein the weight fraction of said dissolved copolymer (C) is less than 2 wt.-%, preferably 1.5 wt.-% or less, based on the total weight of the composition
wherein the ratio between
the total weight of said silver nanowires (B)
and
the weight of said dissolved copolymer (C)
is in the range of from 1:5 to 5:1.

A composition according to the present invention is preparable e.g. by suspending an appropriate amount of the above-defined electroconductive nanoobjects (B) in water and dissolving an appropriate amount of the above-defined one or more copolymers (C) in water, or by combining appropriate amounts of a pre-manufactured aqueous suspension of said electroconductive nanoobjects (B) and of a pre-manufactured aqueous solution of said one or more copolymers (C), or by suspending an appropriate amount of said electroconductive nanoobjects (B) in a pre-manufactured aqueous solution of said one or more copolymers (C), or by dissolving an appropriate amount of said one or more copolymers (C) in a pre-manufactured aqueous suspension of said electroconductive nanoobjects (B). In preferred embodiments, after combining the constituents (A)-(C) and optionally further constituents (as defined above), the composition is subjected to ball-milling in order to improve homogenization of the composition. In certain embodiments, a prolonged homogenization treatment is preferably in order to ensure that the obtained layers have a low haze.

A further aspect of the present invention relates to a method for preparing on a substrate an electroconductive layer having a light transmission of 80 % or more measured according to ASTM D1003 (Procedure A). Said method according to the present invention comprises the steps of:

preparing or providing a composition according to the present invention as defined above, applying said composition to a surface of a substrate,

removing constituents which at 25 °C and 101.325 kPa are liquid from said composition applied to said surface of said substrate to such extent that a layer is formed on said surface of said substrate.

The layer formed by the above-defined process of the invention is a solid electroconductive layer having a light transmission of 80 % or more measured according to ASTM D1003 (Procedure A), said layer comprising or consisting

of solid constituents of said composition according to the present invention as defined above, wherein said layer optionally comprises said one or more of said copolymers (C) in crosslinked form. More specifically, in embodiments where the composition applied to a surface of a substrate comprises one or more copolymers (C) which are cross-linkable, the formed layer comprises said one or more of said copolymers (C) in crosslinked form.

In the context of the present application, the process step of removing constituents which at 25 °C and 101.325 kPa are liquid from said composition applied to said surface of said substrate to such extent that a layer is formed on said surface of said substrate is also referred to as drying. Usually, the liquid constituents are removed by evaporation.

Generally, the liquid constituents have to be removed at least to such extent that on said surface of said substrate an electroconductive layer having a light transmission of 80 % or more measured according to ASTM D1003 (Procedure A) is formed, wherein the one or more copolymers (C) form a contiguous solid phase (also referred to as a matrix) binding the electroconductive nanoobjects (B) which in turn form a conductive network extending throughout said solid matrix. Preferably, said electroconductive layer has a thickness in the range of from 10 nm to 1000 nm, preferably of from 50 nm to 500 nm. Generally the lower limit of the thickness of the electroconductive layer is determined by the smallest dimension of the nanoobjects of the applied composition.

Preferably the constituents which at 25 °C and 101.325 kPa are liquid are completely removed from said composition applied to said surface of said substrate.

Applying said composition according to the invention to said surface of said substrate is preferably carried out by means of a technique selected from the group consisting of spin coating, draw down coating, roll-to-roll coating, gravure printing, microgravure printing, screen-printing, flexoprinting and slot-die coating.

Preferably, said composition is applied to said surface of said substrate in a thickness in a range of from 1 $\mu$m to 200 $\mu$m, preferably of from 2 $\mu$m to 60 $\mu$m. Said thickness is also referred to as "wet thickness" and relates to the state before removing the liquid constituents of the composition as explained above. At a given target thickness (after removing the liquid constituents of the composition as explained above) and accordingly a given target sheet resistance and light transmission of the electroconductive layer to be prepared, the wet thickness may be the higher the lower the concentration of solid constituents in the composition is in the ink. The process of applying the ink is facilitated when there is no constraint to apply the ink in particular low wet thickness.

Said substrate to which said composition according to the present invention (as defined above) is applied is typically an electrical isolator. Preferably said substrate comprises or consists of a material selected from the group consisting of glass and organic polymers. Preferred organic polymers are selected from the group consisting of polycarbonate (PC), cyclic olefin copolymer (COP), polyvinylidene fluoride (PVDF), polyimide (PI) and polyethylene terephthalate (PET). Preferably, said substrate has a light transmission of 80 % or more measured according to ASTM D1003 (Procedure A).

Removing (to such extent as explained above) of those constituents which are liquid at 25 °C and 101.325 kPa from said composition applied to said surface of said substrate is preferably achieved by subjecting said composition applied to said surface of said substrate to a temperature in the range of from 100 °C to 150 °C for a duration of 15 minutes or less. In this regard, the skilled person is aware that said temperature has to be selected under consideration of the thermal stability of the substrate.

Preferred methods according to the present invention are those wherein two or more of the above-defined preferred features are combined.

Regarding the method for preparing an electroconductive layer (as defined above) according to the present invention, the skilled person based on its knowledge adjusts the composition of the ink and all process parameters (of the preparation of the ink as well as of the preparation of the electroconductive layer) in a suitable manner, in order to optimize the sheet resistance and the optical properties of the electroconductive layer, taking into account the technical features of the selected substrate and the available technique for applying the composition according to the invention to the surface of the substrate. If necessary, suitable compositions of the ink and/or process parameters can be easily identified by test procedures known to the person skilled in the art, which do not require undue experimentation.

A further aspect of the present invention relates to an electroconductive layer having a light transmission of 80 % or more as measured according to ASTM D1003 (Procedure A), wherein said electroconductive layer comprises or consists of the solid constituents of a composition according to the present invention as defined above. In said electroconductive layer the one or more copolymers (C) form a contiguous solid phase (also referred to as a matrix) binding the electroconductive nanoobjects (B) which in turn form a conductive network extending throughout said solid matrix. Said electroconductive layer is obtainable by the above-defined method according to the present invention.

Said electroconductive layer optionally comprises said one or more of said copolymers (C) in crosslinked form. More specifically, in embodiments where the composition applied to a surface of a substrate the above-defined method according to the present invention comprises one or more copolymers (C) which are cross-linkable, the formed layer comprises said one or more of said copolymers (C) in crosslinked form.

Light transmission" refers to the percentage of an incident light which is transmitted through a medium. Preferably the light transmission of an electroconductive layer according to the present invention is 85 % or more, more

preferably 90 % or more, further preferably 95 % or more, in each case measured according to ASTM D1003 (Procedure A).

A preferred electroconductive layer according to the present invention exhibits a haze of 2 % or less as measured according to ASTM D1003 (Procedure A), and/or a sheet resistance of 1000 Ohm/square or less as measured by the four point probe.

Preferably the haze of an electroconductive layer according to the present invention is 1.8 % or less, more preferably 1.5 % or less, further preferably 1.2 % or less, in each case measured according to ASTM D1003 (Procedure A).

Preferably the sheet resistance of an electroconductive layer according to the present invention is 800 Ohm/square or less, more preferably 500 Ohm/square or less, further preferably 200 Ohm/square or less, in each case measured by the four point probe.

The measurement of haze and light transmission (in ASTM D1003 referred to as luminous transmittance which is the ratio of the luminous flux transmitted by a body to the flux incident upon it) by means of a hazemeter is defined in ASTM-D1003 as "Procedure A - Hazemeter". The values of haze and light transmission (corresponding to the luminous transmittance as defined in ASTM D1003) given in the context of the present invention refer to this procedure.

Generally, haze is an index of the light diffusion. It refers to the percentage of the quantity of light separated from the incident light and scattered during transmission. Unlike light transmission, which is largely a property of the medium, haze is often a production concern and is typically caused by surface roughness, and by embedded particles or compositional heterogeneities in the medium.

According to ASTM D1003, in transmission, haze is the scattering of light by a specimen responsible for the reduction in contrast of objects viewed through said specimen, i.e. the percent of transmitted light that is scattered so that its direction deviates more than a specified angle (2.5 °) from the direction of the incident beam.

The sheet resistance is a measure of resistance of a thin body (sheet) namely uniform in thickness. The term "sheet resistance" implies that the current flow is along the plane of the sheet, not perpendicular to it. For a sheet having a thickness t, a length L and a width W, the resistance R is

$$R = \rho * \frac{L}{Wt} = \frac{\rho}{t} * \frac{L}{W} = R_{sh} * \frac{L}{W}$$

wherein Rsh is the sheet resistance. Accordingly the sheet resistance $R_{sh}$ is

$$R_{sh} = R * \frac{W}{L}$$

In the formula given above the bulk resistance R is multiplied with a dimensionless quantity (W/L) to obtain the sheet resistance $R_{sh}$, thus the unit of sheet resistance is Ohms. For the sake of avoiding confusion with the bulk resistance R, the value of the sheet resistance is commonly indicated as "Ohms per Square" because in the specific case of a square sheet W = L and R = $R_{sh}$. The sheet resistance is measured by means of a four point-probe.

Further details of the measurement of the sheet resistance and the haze are given below in the examples section.

More preferably, an electroconductive layer according to the present invention exhibits one or more of the following features:

- a haze of 1 % or less as measured according to ASTM D1003 (procedure A),
- a sheet resistance of 100 Ohm/square or less as measured by the four point probe,
- a light transmission of 90 % or more as measured according to ASTM D1003 (procedure A).

Preferred electroconductive layers according to the present invention are those wherein two or more of the above-defined preferred features are combined.

A particularly preferred electroconductive layer according to the present invention exhibits the following features:

- a haze of 1 % or less as measured according to ASTM D1003 (Procedure A), and
- a sheet resistance of 100 Ohm/square or less as measured by the four point probe, and
- a light transmission of 90 % or more as measured according to ASTM D1003 (Procedure A) .

Without wishing to be bound to any theory, it is presently assumed that in an electroconductive layer according to the present invention (as defined above), the network of electroconductive nanoobjects exerts a reinforcing effect on the matrix, thus imparting stability against environmental influences as well as mechanical integrity to said electroconductive layer. In addition, it is assumed that the hydrophobic regions of the one or more copolymers (C) enable strong adhesion to the substrate, especially in the case of a substrate comprising a material selected from the group consisting of organic polymers.

A further aspect of the present invention relates to an article comprising a substrate having a surface and an electroconductive layer according to the invention (as defined above) arranged on at least a portion of said surface of said substrate.

Preferably, said electroconductive layer has a thickness in the range of from 10 nm to 1000 nm, preferably of from 50 nm to 500 nm. The lower limit of the thickness of the electroconductive layer is determined by the smallest dimension of the nanoobjects of the applied composition.

Said substrate is typically an electrical isolator. Preferably said substrate comprises or consists of a material selected from the group consisting of glass and organic polymers. Preferred organic polymers are selected from the group consisting of polycarbonate (PC), cyclic olefin copolymer (COP), polyvinylidene fluoride (PVDF), polyimide (PI) and polyethylene terephthalate (PET). Preferably, said substrate has a light transmission of 80 % or more measured according to ASTM D1003 (Procedure A).

Preferred articles according to the present invention are those wherein two or more of the above-defined preferred features are combined.

Typical applications of electroconductive layers according to the present invention (as defined above) and articles according to the present invention (as defined above) are selected from the group consisting of transparent electrodes, touch panels, wire polarizers, capacitive and resistive touch sensors, EMI shielding, transparent heaters (e.g. for automobile and other applications), flexible displays, plasma displays, electrophoretic displays, liquid crystal displays, transparent antennas, electrochromic devises (e.g. smart windows), photovoltaic devices (especially thin-film photovoltaic cells), electroluminescent devices, light emitting devices (LED) and organic light emitting devices (OLED), flexible devices that can be worn (so-called wearables) such as flexible watches or foldable screens, as well as functional coatings imparting anti-fogging, anti-icing or antistatic properties and dielectric and ferroelectric haptic films. However the present invention is not limited by these applications and can be used in many other electro optical devices by those skilled in the art.

A further aspect of the present invention relates to the use of a composition according to the present invention (as defined above) for the preparation of an electroconductive layer according to the present invention (as defined above) or of an article according to the present invention (as defined above).

The invention is hereinafter further illustrated by means of examples.

## Examples

### 1. Examples of electroconductive layers on glass substrates obtained by spin-coating:

#### 1.1 Compositions comprising no additional binding agent

An aqueous dispersion of silver nanowires (nanoobjects (B) as defined above) and an aqueous solution of a styrene/acrylic copolymer (C) as defined above (Joncryl 60, commercially available from BASF) are mixed so as to obtain an ink having a concentration of silver nanowires and a weight ratio of silver nanowires (B) to dissolved copolymer (C) as indicated in table 1.

The ink is spin-coated (Smart Coater 100) on glass substrates at various spin speeds (see table 1) for 60 sec to generate layers with different wet thickness. The layers are then dried at 130 °C for 5 min.

The sheet resistance Rsh given in Ohms/square (OPS) of the dried layer is measured by a four-point probe station (Lucas lab pro-4) and the optical properties are measured according to ASTM D1003, procedure A-Hazemeter by a haze-gard plus hazemeter (BYK Gardner). The results are compiled in table 1.

With regard to the optical properties, T refers to the light transmission and H refers to the haze of the substrate coated with the electroconductive layer. H(substrate subtracted) refers to the difference between the haze of the substrate coated with the electroconductive layer and the haze of the blank substrate (not coated with the electroconductive layer).

Table 1

| Example No | Concentration of silver nanowires (mg/ml) | Weight ratio silver nanowires / copolymer (C) | Spin Speed (rpm) | Rsh (OPS) | T (%) | H (%) | H (substrate subtrated) (%) |
|---|---|---|---|---|---|---|---|
| 1 | 1.2 | 1:2 | 1000 | 35 | 91.8 | 0.93 | 0.76 |
| 2 | 1.2 | 1:2 | 1500 | 36 | 92.1 | 0.89 | 0.72 |
| 3 | 2.5 | 1:2 | 3000 | 53 | 92.1 | 0.68 | 0.51 |
| 4 | 1.9 | 1:2 | 3000 | 57 | 92.4 | 0.66 | 0.49 |
| 5 | 1.2 | 1:2 | 2500 | 107 | 92.7 | 0.54 | 0.37 |
| 6 | 1.2 | 1:2 | 2000 | 85 | 92.5 | 0.61 | 0.44 |
| 7 | 2.5 | 1:3 | 1000 | 34 | 90.5 | 1.23 | 1.06 |
| 8 | 2.5 | 1:3 | 1500 | 43 | 91.2 | 0.99 | 0.82 |
| 9 | 2.5 | 1:3 | 2000 | 46 | 91.4 | 0.91 | 0.74 |
| 10 | 2.5 | 1:3 | 2500 | 73 | 91.6 | 0.82 | 0.65 |
| 11 | 2.5 | 1:3 | 3000 | 91 | 91.8 | 0.73 | 0.56 |
| 12 | 2.5 | 1:4 | 3000 | 34 | 91 | 1.09 | 0.92 |
| 13 | 1.9 | 1:4 | 1000 | 61 | 91.4 | 0.89 | 0.72 |
| 14 | 1.9 | 1:4 | 1500 | 55 | 91.6 | 0.81 | 0.64 |
| 15 | 1.9 | 1:4 | 2000 | 79 | 92 | 0.74 | 0.57 |
| 16 | 1.9 | 1:4 | 2500 | 99 | 92.2 | 0.63 | 0.46 |
| 17 | 1.9 | 1:4 | 3000 | 88 | 92.2 | 0.59 | 0.42 |
| 18 | 1.6 | 1:1.7 | 750 | 35 | 91.3 | 0.99 | 0.82 |
| 19 | 1.6 | 1:1.7 | 1000 | 42 | 91.9 | 0.75 | 0.58 |
| 20 | 1.6 | 1:1.7 | 1500 | 55 | 92 | 0.68 | 0.51 |
| 21 | 1.6 | 1:1.7 | 3000 | 83 | 92.3 | 0.53 | 0.36 |
| 22 | 1.4 | 1:1.7 | 3000 | 90 | 92.4 | 0.52 | 0.35 |

1.2 Compositions comprising an additional binding agent

An aqueous dispersion of silver nanowires (nanoobjects (B) as defined above) and an aqueous solution of a styrene/acrylic copolymer (C) as defined above (Joncryl 60, commercially available from BASF), said aqueous solution further comprising an additional binding agent, are mixed so as to obtain an ink having a concentration of silver nanowires and a weight ratio of silver nanowires (B) to dissolved copolymer (C) and additional binding agent as indicated in table 2.

The additional binding agent in examples 23-28 is hydroxypropyl methyl cellulose (HPMC, available from Aldrich) dissolved in water, i.e. an additional binding agent (F) as defined above. The additional binding agent in examples 29-32 is a copolymer of 2-ethylhexyl acrylate and methyl methacrylate having a number average molecular weight in the range of from 25000 g/mol to 200000 g/mol in the form of polymer beads having an average diameter of 80 nm dispersed in water (Acronal LR9014 from BASF), i.e. an additional binding agent (D) as defined above

The ink is spin-coated (Smart Coater 100) on glass substrates at various spin speeds (see table 2) for 60 sec to generate layers with different wet thickness. The layers are then dried at 130 °C for 5 min.

The sheet resistance (as defined above) of the dried layer is measured by a four point probe station (Lucas lab pro-4) and the optical properties (as defined above) are measured according to ASTM D1003 procedure A-Hazemeter by a haze-gard plus hazemeter (BYK Gardner). The results are compiled in table 2.

The applied amount of ink is the same in all spin coating examples. The thickness of the dried layer depends on the spin speed when using an ink of a fixed concentration. At high spin speeds there is more ink flowing away from the substrate. Thus, variation of the spin speed can be used to vary the sheet resistance and optical properties (as defined above), so as to match the requirements of different applications of transparent electroconductive layers. High

spin speeds allow for generating very thin layers having high light transmission and low haze, but rather high sheet resistance. In turn, low spin speeds allow for generating thicker layers having a low sheet resistance, but a lower light transmission and a higher haze.

Table 2

| Example No | Concentration of silver nanowires (mg/ml) | Weight ratio silver nanowires / copolymer (C) /additional binding agent | Spin Speed (rpm) | Rsh (OPS) | T (%) | H (%) | H (substrate subtracted) (%) |
|---|---|---|---|---|---|---|---|
| 23 | 2.5 | 2.5:4:1 | 750 | 25 | 90 | 1.59 | 1.42 |
| 24 | 2.5 | 2.5:4:1 | 1000 | 44 | 91 | 1.2 | 1.03 |
| 25 | 2.5 | 2.5:4:1 | 1500 | 60 | 91.6 | 0.98 | 0.81 |
| 26 | 2.1 | 2.5:4:1 | 1000 | 70 | 91.6 | 0.94 | 0.77 |
| 27 | 1.8 | 2.5:4:1 | 1000 | 78 | 91.7 | 0.88 | 0.71 |
| 28 | 1.6 | 2.5:4:1 | 1000 | 125 | 92.3 | 0.73 | 0.56 |
| 29 | 3 | 3:4:2 | 1000 | 25 | 90.1 | 2.01 | 1.84 |
| 30 | 3 | 3:4:2 | 2000 | 51 | 91.3 | 1.3 | 1.13 |
| 31 | 3 | 3:4:2 | 3000 | 80 | 91.8 | 1.08 | 0.91 |
| 32 | 3 | 3:4:2 | 4000 | 208 | 92.7 | 0.62 | 0.45 |

2. Examples of electroconductive layers on polymer substrates obtained by draw-down coating

An aqueous dispersion of silver nanowires (nanoobjects (B) as defined above) and an aqueous solution of a styrene/acrylic copolymer (C) as defined above (Joncryl 60, commercially available from BASF) are mixed so as to obtain an ink having a concentration of silver nanowires and a weight ratio of silver nanowires (B) to dissolved copolymer (C) as indicated in table 3. The ink is ball milled for 30 minutes to improve homogenization.

The ink is applied to a polymer substrate using a draw-down bar (wet thickness t = 6 $\mu$m, coating speed v = 2"/sec) to obtain a layer on said substrate. The layer is then dried at 135 °C for 5 min. In examples 33 and 34 the substrate is an optical polyacarbonate foil (e. g. commercially available under the product specification Makrofol DE 1-1 175$\mu$m from Bayer Material Science). In example 35 the substrate is an optical polyethylene terephthalate foil (Melinex 453/400, Teijing Films).

The sheet resistance (as defined above) of the dried layer is measured by a four point probe station (Lucas lab pro-4) and the optical properties (as defined above) are measured according to ASTM D1003 procedure A-Hazemeter by a haze-gard plus hazeometer (BYK Gardner). The results are compiled in table 3.

Table 3

| Example No | Concentration of silver nanowires (mg/ml) | Weight ratio silver nanowires / copolymer (C) | Rsh (OPS) | T (%) | H (%) | H (substrate subtracted) (%) |
|---|---|---|---|---|---|---|
| 33 | 4 | 1:1.6 | 48.9 | 89.35 | 1.26 | 1.13 |
| 34 | 4 | 1:2 | 47.63 | 89.75 | 1.12 | 0.99 |
| 35 | 3.6 | 1:2 | 130 | 89.5 | 2.01 | 1.51 |

3. Measurement of the adhesion of the electroconductive layer to the substrate

3.1 Spin coating on glass substrate

An aqueous dispersion of silver nanowires (nanoobjects (B) as defined above) and an aqueous solution of a styrene/acrylic copolymer (C) as defined above (Joncryl 60, commercially available from BASF) are mixed so as to obtain an ink having a concentration of silver nanowires of 2.5 mg/ml and a weight ratio of silver nanowires (B) to dissolved copolymer (C) of 1:2.

The ink is spin coated (Smart Coater 100) on a glass substrate at 3000 rpm for 60 sec to generate a layer. The layer is then dried at 130 °C for 5 min.

The adhesion of the electroconductive layer to the substrate is examined by the Scotch tape test as follows: A fresh piece of commercial 3M Scotch tape (e. g. commercially available under the product specification Scotch D. Art. Nr. 11257 from 3M) is pressed onto the surface of the electroconductive layer and then peeled off. This procedure is repeated so that the total number of peeling steps is 10. The sheet resistance (as defined above) of the dried electroconductive layer step is measured by a four point probe station (Lucas lab pro-4) before the first peeling step and after the 10th peeling step. As can be seen from table 4 the sheet resistance has not significantly changed after completion of 10 peeling steps. Accordingly, the layer has a strong adhesion to the substrate.

Table 4

| Number of peeling steps | Rsh (OPS) |
|---|---|
| 0 | 54 |
| 10 | 54 |

3.2 Draw-down coating on a plastic substrate

The electroconductive layer of example 35 described above was subject to the adhesion test described above. The peeling procedure is repeated so that the total number of peeling steps is 8. The sheet resistance (as defined above) of the dried electroconductive layer step is measured by a four point probe station (Lucas lab pro-4) before the first peeling step and after the 8th peeling step. As can be seen from table 5 the sheet resistance has not significantly changed after completion of 8 peeling steps. Accordingly, the layer has a strong adhesion to the substrate.

Table 5

| Number of peeling steps | Rsh (OPS) |
|---|---|
| 0 | 130 |
| 8 | 131 |

4, Conclusion

The examples as presented above show that the compositions according to the present invention (as defined above) are suitable for the preparation of an electroconductive transparent layer having

- a light transmission of 80 % or more, in preferred embodiments of 90 % or more measured according to ASTM D1003, and
- a sheet resistance of 1000 Ohm/square or less, in preferred embodiments less than 100 Ohm/square, and
- in preferred embodiments a haze more measured according to ASTM D1003 of 2 % or less, in further preferred embodiments of 1.5 % or less and in particularly preferred embodiments of 1 % or less
- a strong adhesion to the substrate.

The above examples show that the haze of the obtained electroconductive layers increases, when the concentration of solid components in the ink used for layer preparation increases, provided that all other coating parameters remain unchanged. This is evident from examples 7, 29 and 33-35 each using an ink having a rather high concentration of solid constituents (but still within the range according to the present invention).. Accordingly, it is concluded that the haze of the obtained electroconductive layer is significantly higher when using the ink according to US 2008/0182090, which has a significantly higher concentration of solid constituents, compared to the composition of the present invention (as defined above). However, for applications like touch panels a high haze is detrimental.

**Claims**

1. Composition comprising the constituents

(A) water,
(B) electroconductive nanoobjects,
said electroconductive nanoobjects (B) having two external dimensions in the range of from 1 nm to 100 nm and their third external dimension in the range of from 1 μm to 100 μm
wherein the weight fraction of said electroconductive nanoobjects (B) is in the range of from 0.01 wt.-% to 1 wt.-% based on the total weight of the composition,
(C) dissolved in the water one or more styrene/(meth)acrylic copolymers,
said dissolved copolymers (C) each having a number average molecular weight in the range of from 500 g/mol to 22000 g/mol wherein the total weight fraction of said dissolved copolymers (C) is in the range of from 0.02 wt.-% to 5 wt.-%, based on the total weight of the composition

with the proviso that when the composition comprises one or more additional binding agents which are capable of co-acting with the above-defined one or more copolymers (C) in forming a matrix and binding said electroconductive nanoobjects (B), the total weight fraction of said additional binding agents, based on the total weight of the composition, is equal to or less than the total weight fraction of said dissolved copolymers (C) based on the total weight of the composition.

2. Composition according to claim 1, wherein said electroconductive nanoobjects (B) have
a length in the range of from 1 μm to 100 μm,
and
a diameter in the range of from 1 nm to 100 nm.

3. Composition according to claim 1, wherein said electroconductive nanoobjects (B) comprise one or more materials selected from the group consisting of silver, copper, gold and carbon.

4. Composition according to any preceding claim
wherein said electroconductive nanoobjects (B) are selected from the group consisting of nanowires and nanotubes.

5. Composition according to any preceding claim, wherein the ratio between the total weight of said electroconductive nanoobjects (B)
and
the total weight of said dissolved copolymers (C)
is in the range of from 1 : 20 to 20 : 1.

6. Composition according to any preceding claim, comprising

(A) water
(B) silver nanowires
said silver nanowires (B) having a length in the range of from 10 μm to 50 μm and a diameter in the range of from 3 nm to 30 nm wherein the weight fraction of said silver nanowires (B) is 0.5 wt.-% or less, based on the total weight of the composition
(C) dissolved in the water a styrene/(meth)acrylic copolymer,
said dissolved copolymer (C) having a number average molecular weight in the range of from 1700 g/mol to 15500 g/mol
wherein the weight fraction of said dissolved copolymer (C) is less than 2 wt.-%, preferably 1.5 wt.-% or less, based on the total weight of the composition

wherein the ratio between
the total weight of said silver nanowires (B)
and
the weight of said dissolved copolymer (C)
is in the range of from 1:5 to 5:1.

7. Method for preparing an electroconductive layer having a light transmission of 80 % or more measured according

to ASTM D1003 (procedure A), on a substrate, comprising the steps of:

preparing or providing a composition according to any of claims 1-6,
applying said composition to a surface of a substrate,
removing constituents which at 25 °C and 101.325 kPa are liquid from said composition applied to said surface of said substrate to such extent that a layer is formed on said surface of said substrate.

**8.** Method according to claim 7, wherein applying said composition to said surface of said substrate is carried out by means of a technique selected from the group consisting of spin coating, draw down coating, roll-to-roll coating, gravure printing, microgravure printing, screen-printing, flexoprinting and slot-die coating.

**9.** Method according to claim 7 or 8, wherein said substrate comprises a material selected from the group consisting of glass and organic polymers.

**10.** Method according to any of claims 7 to 9, wherein removing of those constituents, which are liquid at 25 °C and 101.325 kPa from said composition applied to said surface of said substrate is achieved by subjecting said composition applied to said surface of said substrate to a temperature in the range of from 100 °C to 150 °C for a duration of 15 minutes or less.

**11.** Electroconductive layer having a light transmission of 80 % or more measured according to ASTM D1003 (procedure A), wherein said electroconductive layer consists of the constituents of a composition according to claims 1-6 which at 25 °C and 101.325 kPa are solid.

**12.** Electroconductive layer according to claim 11, wherein said electroconductive layer exhibits

- a haze of 2 % or less as measured according to ASTM D1003 (procedure A),
and
- a sheet resistance of 1000 Ohm/square or less as measured by the four point probe.

**13.** Electroconductive layer according to claim 11 or 12, wherein said electroconductive layer exhibits one or more of

- a haze of 1 % or less as measured according to ASTM D1003 (procedure A),
- a sheet resistance of 100 Ohm/square or less as measured by the four point probe,
- a light transmission of 90 % or more as measured according to ASTM D1003 (procedure A).

**14.** Article comprising

- a substrate having a surface
and
- an electroconductive layer according to any of claims 11-13 arranged on at least a portion of said surface of said substrate,

wherein said electroconductive layer preferably has a thickness in the range of from 10 nm to 1000 nm, preferably of from 50 nm to 500 nm.

**15.** Use of a composition according to any of claims 1-6 for the preparation of an item selected from

- an electroconductive layer according to any of claims 11-13
- an article according to claim 14.

**Patentansprüche**

**1.** Zusammensetzung, umfassend die Bestandteile

(A) Wasser,
(B) elektrisch leitfähige Nanoobjekte,
wobei die elektrisch leitfähigen Nanoobjekte (B) zwei Außenabmessungen in dem Bereich von 1 nm bis 100

nm und die dritte Außenabmessung in dem Bereich von 1 μm bis 100 μm aufweisen,
wobei der Gewichtsanteil der elektrisch leitfähigen Nanoobjekte (B) in dem Bereich von 0,01 Gew.-% bis 1 Gew.-%, bezogen auf das Gesamtgewicht der Zusammensetzung, liegt,
(C) ein oder mehrere in dem Wasser gelöste Styrol/(Meth)acryl-Copolymere,
wobei die gelösten Copolymere (C) jeweils ein anzahlgemitteltes Molekulargewicht in dem Bereich von 500 g/mol bis 22000 g/mol aufweisen,
wobei der Gesamtgewichtsanteil der gelösten Copolymere (C) in dem Bereich von 0,02 Gew.-% bis 5 Gew.-%, bezogen auf das Gesamtgewicht der Zusammensetzung, liegt,

mit der Maßgabe, dass, wenn die Zusammensetzung ein oder mehrere zusätzliche Bindemittel umfasst,
die fähig sind, mit dem einen oder mehreren, vorstehend definierten Copolymeren (C) zusammenzuwirken, um eine Matrix zu bilden und die elektrisch leitfähigen Nanoobjekte (B) zu binden,
der Gesamtgewichtsanteil der zusätzlichen Bindemittel, bezogen auf das Gesamtgewicht der Zusammensetzung, gleich oder kleiner als der Gesamtgewichtsanteil der gelösten Copolymere (C), bezogen auf das Gesamtgewicht der Zusammensetzung, ist.

**2.** Zusammensetzung gemäß Anspruch 1, wobei die elektrisch leitfähigen Nanoobjekte (B) aufweisen:

eine Länge in dem Bereich von 1 μm bis 100 μm
und
einen Durchmesser in dem Bereich von 1 nm bis 100 nm.

**3.** Zusammensetzung gemäß Anspruch 1, wobei die elektrisch leitfähigen Nanoobjekte (B) ein oder mehrere Materialien ausgewählt aus der Gruppe bestehend aus Silber, Kupfer, Gold und Kohlenstoff umfassen.

**4.** Zusammensetzung gemäß einem der vorstehenden Ansprüche,
wobei die elektrisch leitfähigen Nanoobjekte (B) ausgewählt sind aus der Gruppe bestehend aus Nanodrähten und Nanoröhrchen.

**5.** Zusammensetzung gemäß einem der vorstehenden Ansprüche, wobei das Verhältnis zwischen
dem Gesamtgewicht der elektrisch leitfähigen Nanoobjekte (B)
und
dem Gesamtgewicht der gelösten Copolymere (C)
in dem Bereich von 1:20 bis 20:1 liegt.

**6.** Zusammensetzung gemäß einem der vorstehenden Ansprüche, umfassend

(A) Wasser,
(B) Silber-Nanodrähte,
wobei die Silber-Nanodrähte (B) eine Länge in dem Bereich von 10 μm bis 50 μm und einen Durchmesser in dem Bereich von 3 nm bis 30 nm aufweisen,
wobei der Gewichtsanteil der Silber-Nanodrähte (B) 0,5 Gew.-% oder weniger,
bezogen auf das Gesamtgewicht der Zusammensetzung, beträgt,
(C) ein in dem Wasser gelöstes Styrol/(Meth)acryl-Copolymer,
wobei das gelöste Copolymer (C) ein anzahlgemitteltes Molekulargewicht in dem Bereich von 1700 g/mol bis 15500 g/mol aufweist,
wobei der Gesamtgewichtsanteil des gelösten Copolymers (C) weniger als 2 Gew.-%, vorzugsweise 1,5 Gew.-% oder weniger, bezogen auf das Gesamtgewicht der Zusammensetzung, beträgt,

wobei das Verhältnis zwischen
dem Gesamtgewicht der Silber-Nanodrähte (B)
und
dem Gewicht des gelösten Copolymers (C) in dem Bereich von 1:5 bis 5:1 liegt.

**7.** Verfahren zur Herstellung einer elektrisch leitfähigen Schicht mit einer Lichtdurchlässigkeit von 80 % oder mehr, gemessen gemäß ASTM D1003 (Verfahren A), auf einem Substrat,
umfassend die Schritte:

Herstellen oder Bereitstellen einer Zusammensetzung gemäß einem der Ansprüche 1-6,
Aufbringen der Zusammensetzung auf eine Oberfläche eines Substrats,
Entfernen von Bestandteilen, die bei 25 °C und 101,325 kPa flüssig sind, aus der auf die Oberfläche des Substrats aufgebrachten Zusammensetzung zu einem solchen Maß, dass eine Schicht auf der Oberfläche des Substrats gebildet wird.

**8.** Verfahren gemäß Anspruch 7, wobei das Aufbringen der Zusammensetzung auf die Oberfläche des Substrats durch ein Verfahren ausgewählt aus der Gruppe bestehend aus Schleuderbeschichtung, Drawdown-Beschichtung, Rolle-zu-Rolle-Beschichtung, Tiefdruck, Mikrotiefdruck, Siebdruck, Flexodruck und Schlitzdüsenbeschichtung durchgeführt wird.

**9.** Verfahren gemäß Anspruch 7 oder 8, wobei das Substrat ein Material ausgewählt aus der Gruppe bestehend aus Glas und organischen Polymeren umfasst.

**10.** Verfahren gemäß einem der Ansprüche 7 bis 9, wobei das Entfernen der Bestandteile, die bei 25 °C und 101,325 kPa flüssig sind, aus der auf die Oberfläche des Substrats aufgebrachten Zusammensetzung durch Unterwerfen der auf die Oberfläche des Substrats aufgebrachten Zusammensetzung an eine Temperatur in dem Bereich von 100 °C bis 150 °C für eine Dauer von 15 Minuten oder weniger durchgeführt wird.

**11.** Elektrisch leitfähige Schicht mit einer Lichtdurchlässigkeit von 80 % oder mehr, gemessen gemäß ASTM D1003 (Verfahren A), wobei die elektrisch leitfähige Schicht aus den Bestandteilen einer Zusammensetzung gemäß Ansprüchen 1-6, die bei 25 °C und 101,325 kPa fest sind, besteht.

**12.** Elektrisch leitfähige Schicht gemäß Anspruch 11, wobei die elektrisch leitfähige Schicht aufweist:

- eine Trübung von 2 % oder weniger, wie gemessen gemäß ASTM D1003 (Verfahren A),
und
- einen Flächenwiderstand von 1000 Ohm/Quadrat oder weniger, wie gemessen durch eine Vierpunktsonde.

**13.** Elektrisch leitfähige Schicht gemäß Anspruch 11 oder 12, wobei die elektrisch leitfähige Schicht eines oder mehrere aufweist von:

- einer Trübung von 1 % oder weniger, wie gemessen gemäß ASTM D1003 (Verfahren A),
- einem Flächenwiderstand von 100 Ohm/Quadrat oder weniger, wie gemessen durch eine Vierpunktsonde,
- einer Lichtdurchlässigkeit von 90 % oder mehr, wie gemessen gemäß ASTM D1003 (Verfahren A).

**14.** Gegenstand, umfassend

- ein Substrat mit einer Oberfläche
und
- eine elektrisch leitfähige Schicht gemäß einem der Ansprüche 11-13, die auf wenigstens einem Teil der Oberfläche des Substrats angeordnet ist,

wobei die elektrisch leitfähige Schicht vorzugsweise eine Dicke in dem Bereich von 10 nm bis 1000 nm, vorzugsweise von 50 nm bis 500 nm, aufweist.

**15.** Verwendung einer Zusammensetzung gemäß einem der Ansprüche 1-6 für die Herstellung eines Gegenstands ausgewählt aus

- einer elektrisch leitfähigen Schicht gemäß einem der Ansprüche 11-13,
- einem Gegenstand gemäß Anspruch 14.

**Revendications**

**1.** Composition comprenant les constituants suivants :

(A) de l'eau,

(B) des nanoobjets électroconducteurs,
lesdits nanoobjets électroconducteurs (B) ayant deux dimensions externes dans la gamme de 1 nm à 100 nm et leur troisième dimension externe dans la gamme de 1 μm à 100 μm,
la fraction pondérale desdits nanoobjets électroconducteurs (B) se situant dans la gamme de 0,01 % en poids à 1 % en poids, rapporté au poids total de la composition,
(C) dissous dans l'eau, un ou plusieurs copolymères styrène/(méth)acrylique,
lesdits copolymères dissous (C) ayant chacun un poids moléculaire moyen en nombre dans la gamme de 500 g/mol à 22 000 g/mol,
la fraction pondérale totale desdits copolymères dissous (C) se situant dans la gamme de 0,02 % en poids à 5 % en poids, rapporté au poids total de la composition,
à condition que, lorsque la composition comprend un ou plusieurs liants supplémentaires qui peuvent agir de concert avec le ou les copolymères (C) définis ci-dessus dans la formation d'une matrice et la liaison desdits nanoobjets électroconducteurs (B), la fraction pondérale totale desdits liants supplémentaires rapportée au poids total de la composition soit égale ou inférieure à la fraction pondérale totale desdits copolymères dissous (C) rapportée au poids total de la composition.

**2.** Composition selon la revendication 1, dans laquelle lesdits nanoobjets électroconducteurs (B) ont
une longueur dans la gamme de 1 μm à 100 μm,
et
un diamètre dans la gamme de 1 nm à 100 nm.

**3.** Composition selon la revendication 1, dans laquelle lesdits nanoobjets électroconducteurs (B) comprennent un ou plusieurs matériaux choisis dans le groupe constitué par l'argent, le cuivre, l'or et le carbone.

**4.** Composition selon une quelconque revendication précédente,
dans laquelle lesdits nanoobjets électroconducteurs (B) sont choisis dans le groupe constitué par les nanofils et les nanotubes.

**5.** Composition selon une quelconque revendication précédente, dans laquelle le rapport entre
le poids total desdits nanoobjets électroconducteurs (B)
et
le poids total desdits copolymères dissous (C) se situe dans la gamme de 1:20 à 20:1.

**6.** Composition selon une quelconque revendication précédente, comprenant

(A) de l'eau,
(B) des nanofils d'argent,
lesdits nanofils d'argent (B) ayant une longueur dans la gamme de 10 μm à 50 μm et un diamètre dans la gamme de 3 nm à 30 nm,
la fraction pondérale desdits nanofils d'argent (B) étant de 0,5 % en poids ou moins, rapporté au poids total de la composition,
(C) dissous dans l'eau, un copolymère styrène/ (méth)acrylique,
ledit copolymère dissous (C) ayant un poids moléculaire moyen en nombre dans la gamme de 1700 g/mol à 15 500 g/mol,
la fraction pondérale dudit copolymère dissous (C) étant inférieure à 2 % en poids, de préférence de 1,5 % en poids ou moins, rapporté au poids total de la composition,
dans laquelle le rapport entre
le poids total desdits nanofils d'argent (B)
et
le poids dudit copolymère dissous (C)
se situe dans la gamme de 1:5 à 5:1.

**7.** Procédé de préparation d'une couche électroconductrice ayant une transmission lumineuse de 80 % ou plus, mesurée selon la méthode ASTM D1003 (procédure A), sur un substrat,
comprenant les étapes de :

préparation ou obtention d'une composition selon l'une quelconque des revendications 1 à 6,
application de ladite composition à une surface d'un substrat,

retrait de constituants qui à 25 °C et 101,325 kPa sont liquides de ladite composition appliquée à ladite surface dudit substrat jusqu'à un degré tel qu'une couche soit formée sur ladite surface dudit substrat.

**8.** Procédé selon la revendication 7, dans lequel l'application de ladite composition à ladite surface dudit substrat est réalisée au moyen d'une technique choisie dans le groupe constitué par le dépôt à la tournette, le dépôt à l'applicateur spiralé, le revêtement au rouleau, la rotogravure, l'impression par microgravure, la sérigraphie, l'impression flexographique et l'enduction par filière plate.

**9.** Procédé selon la revendication 7 ou 8, dans lequel ledit substrat comprend un matériau choisi dans le groupe constitué par le verre et les polymères organiques.

**10.** Procédé selon l'une quelconque des revendications 7 à 9, dans lequel le retrait des constituants qui sont liquides à 25 °C et 101,325 kPa de ladite composition appliquée à ladite surface dudit substrat est réalisé en soumettant ladite composition appliquée à ladite surface dudit substrat à une température dans la gamme de 100 °C à 150 °C pendant une durée de 15 minutes ou moins.

**11.** Couche électroconductrice ayant une transmission lumineuse de 80 % ou plus, mesurée selon la méthode ASTM D1003 (procédure A), ladite couche électroconductrice consistant en les constituants d'une composition selon les revendications 1 à 6 qui, à 25 °C et 101,325 kPa, sont solides.

**12.** Couche électroconductrice selon la revendication 11, ladite couche électroconductrice présentant

- un trouble de 2 % ou moins tel que mesuré selon la méthode ASTM D1003 (procédure A),
et
- une résistance de couche de 1000 ohms/carré ou moins telle que mesurée par la sonde à quatre points.

**13.** Couche électroconductrice selon la revendication 11 ou 12, ladite couche électroconductrice présentant une ou plusieurs des propriétés suivantes :

- un trouble de 1 % ou moins tel que mesuré selon la méthode ASTM D1003 (procédure A),
- une résistance de couche de 100 ohms/carré ou moins telle que mesurée par la sonde à quatre points,
- une transmission lumineuse de 90 % ou plus telle que mesurée selon la méthode ASTM D1003 (procédure A).

**14.** Article comprenant

- un substrat ayant une surface
et
- une couche électroconductrice selon l'une quelconque des revendications 11 à 13 disposée sur au moins une partie de ladite surface dudit substrat,
ladite couche électroconductrice ayant de préférence une épaisseur dans la gamme de 10 nm à 1000 nm, de préférence de 50 nm à 500 nm.

**15.** Utilisation d'une composition selon l'une quelconque des revendications 1 à 6 pour la préparation d'un élément choisi parmi

- une couche électroconductrice selon l'une quelconque des revendications 11 à 13,
- un article selon la revendication 14.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 8049333 B
- US 20080182090 A1
- WO 2013073259 A1
- US 20110171364 A1
- US 20110097277 A1
- US 20060167147 A1
- US 20080182090 A
- US 4414370 A
- US 4529787 A
- US 4546160 A
- US 5508366 A
- US 7999045 B2

### Non-patent literature cited in the description

- **YUGANG SUN ; YOUNAN XIA.** *Adv. Mater,* 05 June 2002, vol. 14 (11), 833-837